# FASCICULE DE BREVET EUROPEEN

(11) **EP 2 291 067 B1**
(45) Date de publication et mention de la délivrance du brevet: **24.04.2013**
(21) Numéro de dépôt: 10305872.3
(22) Date de dépôt: 09.08.2010
(51) Int. Cl.: H05K 7/20, H01L 23/427

(54) **Convertisseur de puissance électrique refroidi par une technologie statique**
Stromrichter, insbesondere für ein Schienentriebfahrzeug
Electric power converter for railway traction vehicle

(30) Priorité: 27.08.2009 FR 0955846
(43) Date de publication de la demande: 02.03.2011
(73) Titulaire: ALSTOM Transport SA, 92300 Levallois-Perret (FR)
(72) Inventeur: DUPONT, Vincent, 1040, ETTERBEEK (BE); NICOLAU, Sébastien, 65100, LOUBAJAC (FR); MERMET-GUYENNET, Michel, 65390, AURENSAN (FR)
(74) Mandataire: Blot, Philippe Robert Emile

(56) Documents cités:
- EP-A1- 1 259 104
- EP-A2- 1 988 762
- WO-A1-97/00416
- US-A1- 2003 042 009
- US-A1- 2008 164 010

## Description

La présente invention concerne un convertisseur de puissance électrique, du type comportant :
- un composant électrique de puissance propre à participer à la conversion du courant électrique ;
- une boucle fermée de refroidissement comprenant
   - un fluide caloporteur diphasique ;
   - un premier échangeur thermique appliqué contre ledit composant électrique de puissance ;
   - un deuxième échangeur thermique propre à évacuer la chaleur du fluide caloporteur hors de la boucle de refroidissement ;
   - des moyens de mise en circulation du fluide caloporteur dans la boucle de refroidissement.

La présente invention concerne un convertisseur de puissance électrique refroidi par CPL pouvant être utilisé dans les différents secteurs, et notamment des équipements de transport ferroviaire, à savoir des véhicules ferroviaires, des équipements de production d'énergie, et des équipements de transmission d'électricité.

Les différents équipements susceptibles d'intégrer cette technologie de refroidissement dans la partie conversion d'énergie sont les transformateurs moyenne fréquence, les éoliennes, les hydroliennes, les turbines, les coffres de traction, les moteurs électriques, les bogie et moteur intégrés, les sous-stations d'alimentation, les batteries, les super capa, les volants d'inertie et les alimentations auxiliaires.

Les véhicules ferroviaires nécessitent, pour l'alimentation électrique des moteurs de traction, de disposer de convertisseurs de puissance électrique embarqués. Du fait des puissances très importantes, les convertisseurs doivent être refroidis pour évacuer la chaleur produite par les organes de commutation des convertisseurs.

Actuellement, le refroidissement est assuré par une boucle dans laquelle circule de l'eau glycolée. L'eau glycolée circule en circuit fermé entre un premier échangeur en contact avec les organes de commutation et un second échangeur à air. Une pompe hydraulique assure la mise en mouvement de l'eau glycolée.

Un tel circuit de refroidissement est relativement encombrant, notamment du fait des pompes, et nécessite un entretien important, également lié à la présence des pompes, ce qui augmente les coûts d'exploitation et de maintenance du véhicule ferroviaire.

EP 1 988 762 décrit un module électrique de puissance refroidi par changement de phase et WO 97/00416 décrit une boucle à pompage capillaire de transfert de chaleur.

L'invention a pour but de proposer un convertisseur de puissance électrique pour un véhicule ferroviaire peu encombrant et nécessitant une maintenance réduite.

A cet effet, l'invention a pour objet un convertisseur de puissance électrique selon la revendication 1.

Suivant des modes particuliers de réalisation, le convertisseur de puissance électrique comporte l'une ou plusieurs des caractéristiques des revendications dépendantes.

L'invention a également pour objet un véhicule ferroviaire comportant une chaîne de traction comportant un moteur électrique et un convertisseur de puissance électrique tel que défini ci-dessus.

L'invention sera mieux comprise à la lecture de la description qui va suivre, donnée uniquement à titre d'exemple, et faite en se référant aux dessins, sur lesquels :
- la figure 1 est une vue en perspective d'un convertisseur embarqué selon l'invention ;
- la figure 2 est une vue schématique du circuit de refroidissement du convertisseur de la figure 1 ;
- la figure 3 est un organigramme d'un algorithme mis en oeuvre pour la commande du convertisseur selon l'invention ; et
- la figure 4 est une courbe explicitant pour un exemple la puissance thermique produite par les organes de commutation du convertisseur lors d'une phase de traction ; et
- la figure 5 est une courbe représentent pour la phase de traction explicité à la figure 4, la température de jonction de composants électriques.

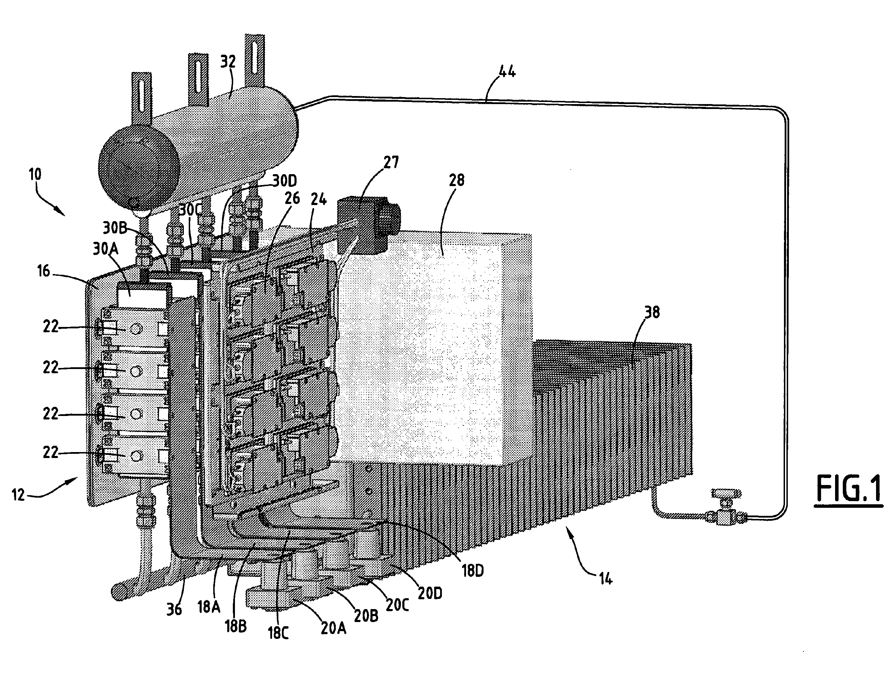

Sur la figure 1 est représenté un convertisseur de puissance électrique 10 pour un véhicule ferroviaire. Ce convertisseur est normalement embarqué dans une locomotive ou dans un véhicule moteur d'une rame de transport de passagers ou de fret. Le convertisseur 10 alimente dans le véhicule un moteur électrique d'une chaîne de traction. Il comporte, comme connu en soi un onduleur 12, ici à quatre phases, et un circuit 14 de refroidissement de l'onduleur 12.

L'onduleur est propre à transformer un courant continu provenant par exemple de la caténaire en un courant triphasé avec une fonction rhéostatique associée.

Ainsi, il comporte un bus d'entrée continu 16 constitué ici d'une plaque métallique et quatre barres de conduction de puissance 18A, 18B, 18C, 18D correspondant chacune à une phase de l'onduleur et à la fonction rhéostatique. Ces quatre barres sont munies à leurs extrémités d'un plot de connexion 20A, 20B, 20C, 20D de sortie.

Entre le bus 16 et chaque barre de puissance 18A, 18B, 18C, 18D sont disposés quatre organes de commutation à semi-conducteur 22 montés en parallèle. Ces organes 22 forment chacun un transistor bipolaire à grille isolée (connu sous l'acronyme anglais « IGBT » pour « Insulated Gate Bipolar Transistor ».)

Le long des barres de puissance est disposée une carte allumeur 24 comportant un ensemble de circuits 26 pour la commande des organes de commutation 22 reliant sélectivement le bus continu 16 aux barres de puissance 18A, 18B, 18C, 18D. La carte allumeur 24 est pourvue d'un connecteur 27 pour recevoir des ordres de pilotage.

En outre, un filtre capacitif 28 est placé à côté des organes de commutation 22 et est connecté comme connu en soi.

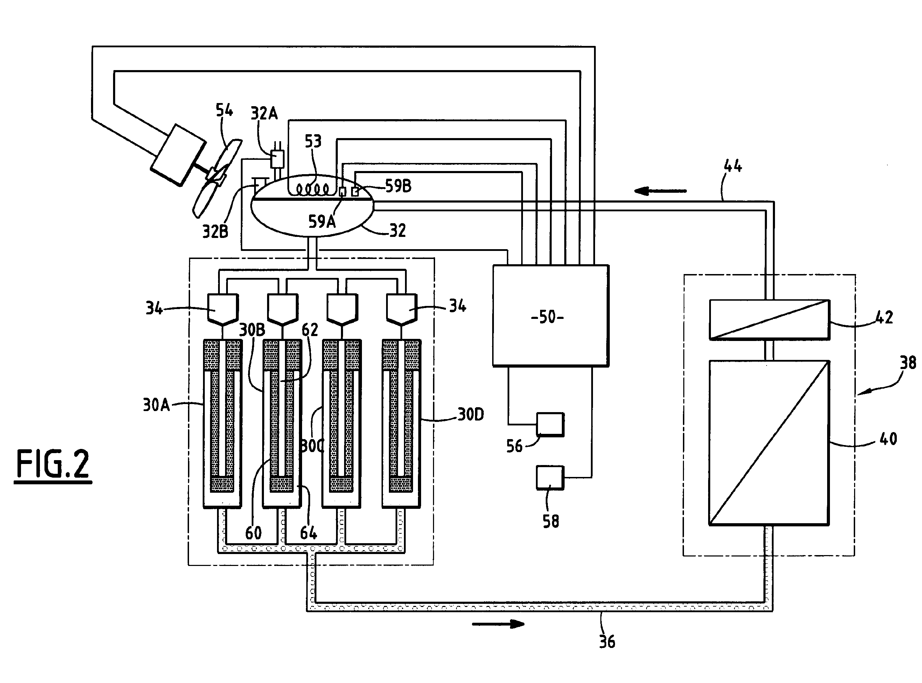

Le circuit de refroidissement 14, représentée schématiquement sur la figure 2, assure la dissipation de la chaleur produite par les organes de commutation 22 et le maintien de la température de jonction de ces organes de commutation à une valeur sensiblement constante.

Le circuit de refroidissement constitue une boucle à pompage capillaire dépourvue de toute pompe électromécanique. Le fluide de refroidissement est par exemple du méthanol.

A cet effet, la boucle 14 comporte, associé à chaque groupe d'organes de commutation alimentant une même barre de puissance depuis le bus continu 16, un évaporateur capillaire 30A, 30B, 30C, 30D plaqué contre une surface d'échanges de chaque organe de commutation. Ces évaporateurs capillaires constituent des premiers échangeurs de chaleur propre à transférer la chaleur produite par les organes de commutation dans la boucle 14.

Ces évaporateurs capillaires 30A, 30B, 30C, 30D sont montés en parallèle et sont disposés verticalement pour recevoir, dans leurs parties supérieures, le fluide de refroidissement circulant dans la boucle 14 en phase liquide et produire à leurs extrémités inférieures de la vapeur du même fluide.

Ainsi, le fluide de refroidissement circulant dans la boucle 14 est un fluide diphasique, celui-ci étant sous forme de liquide seulement dans certaines parties du circuit et sous forme de vapeur seulement dans d'autres parties du circuit.

Depuis leurs extrémités supérieures, les quatre évaporateurs capillaires 30A, 30B, 30C, 30D sont reliés à un même réservoir pressurisateur diphasique 32 de fluide de refroidissement par l'intermédiaire de quatre isolateurs 34 propres à empêcher un retour de vapeur vers le réservoir, par exemple en cas de désamorçage d'un évaporateur créé par une trop forte injection de puissance thermique.

Le réservoir est équipé d'une soupape de dégazage commandable 32A placée au sommet du réservoir 32 et d'un orifice de remplissage 32B normalement fermé.

Les sorties inférieures de vapeur des quatre évaporateurs capillaires se rejoignent en une conduite 36 de transfert de vapeur alimentant l'entrée d'un étage de condensation 38.

Cet étage comporte un condenseur principal 40 propre à assurer un échange thermique entre la vapeur issue des évaporateurs capillaires et le milieu ambiant. A cet effet, le condenseur 40 présente des ailettes latérales en contact avec l'atmosphère environnant.

En aval du condenseur principal 40, l'étage de condensation 38 comporte un échangeur de sous-refroissement 42 propre à condenser la vapeur, qui, accidentellement aurait pu ne pas être totalement condensée dans le condenseur principal 40.

La sortie de l'étage de condensation 38 est reliée par une conduite 44 de transport du fluide de refroidissement à l'état liquide jusqu'au réservoir 32.

Le réservoir 32 est placé à la vertical des évaporateurs capillaires 30A, 30B, 30C, 30D, le liquide de refroidissement étant soutiré du réservoir pour alimenter par pompage par dépression et par gravité les évaporateurs capillaires.

Le réservoir 32 présente une phase liquide surmontée par un ciel gazeux.

Pour assurer une régulation de la température de jonction des organes de commutation 22, le réservoir 32 est équipé de moyens de chauffage et de refroidissement reliés à une unité centrale de pilotage 50.

Ainsi, une résistance chauffante 52 est placée dans le ciel gazeux du réservoir 32 pour assurer un échauffement. De même, un ventilateur 54 est placé en regard du réservoir pour assurer le refroidissement de celui-ci.

La résistance 52 et le ventilateur 54 sont pilotés par l'unité de pilotage 50, laquelle est reliée à un capteur 56 de mesure de la puissance électrique consommée par le moteur, celle-ci étant par exemple définie à partir du manipulateur d'accélération du véhicule ferroviaire à la disposition du conducteur.

De même, l'unité 50 est reliée à un capteur 58 de mesure de la température de jonction des organes de commutation 22.

Enfin, un capteur de pression 59A et un capteur de température 59B reliés à l'unité 50 sont disposés dans le ciel gazeux du réservoir 32.

L'unité 50 est reliée à la soupape 32A pour sa commande.

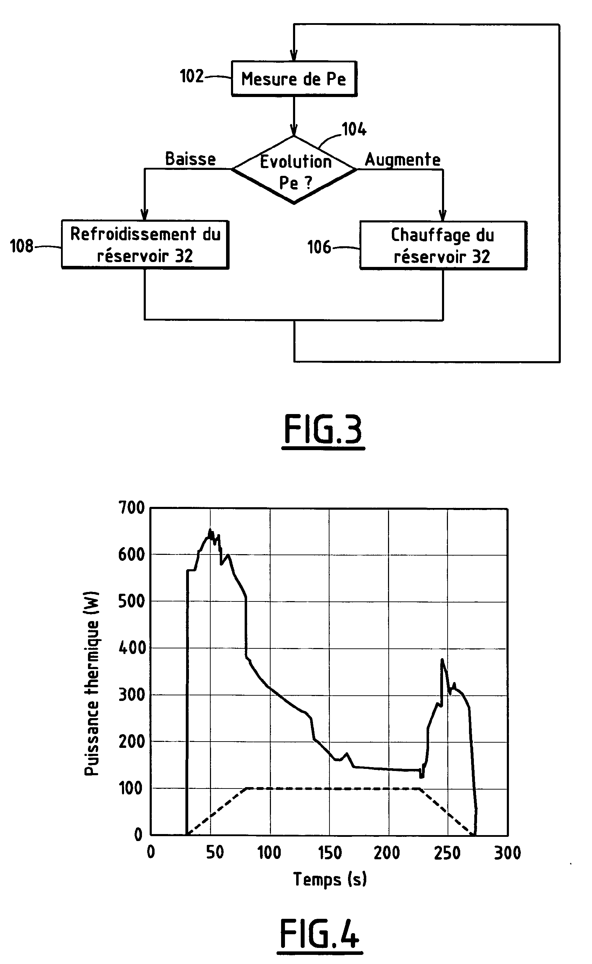

L'unité 50 est propre à mettre en oeuvre un algorithme tel qu'illustré schématiquement sur la figure 3.

Les évaporateurs capillaires 30A, 30B, 30C, 30D constituent des pompes capillaires propres à recevoir en entrée le fluide de refroidissement à l'état liquide et à délivrer en sortie ce fluide en phase vapeur uniquement.

Comme illustré sur la figure 3, l'évaporateur capillaire est formé d'un réservoir fermé, à l'exception de son entrée et de sa sortie. Il présente une forme parallélépipédique, sur une face duquel sont appliqués les organes de commutation 22.

Une mèche capillaire 60 est logée à l'intérieur du réservoir et définit dans l'évaporateur une chambre interne 62 de réception du fluide de refroidissement à l'état liquide et une chambre périphérique de sortie du fluide de refroidissement à l'état vapeur 64. Ces deux chambres 62 et 64 sont parfaitement séparées par la mèche capillaire, de sorte que seul du liquide existe dans la chambre 62 et seule de la vapeur est présente dans la chambre 64, les deux phases liquide et vapeur étant parfaitement séparées. La circulation du fluide de refroidissement s'effectue donc de manière radiale de la chambre 62 vers la chambre externe 64.

Chaque évaporateur capillaire assure une transformation du fluide de refroidissement à l'état liquide en vapeur sous l'action de la chaleur produite par les organes de commutation. Ces évaporateurs capillaires assurent le rôle de pompe dans le circuit fermé 14.

La mise en circulation du fluide résulte de l'augmentation de la pression de vapeur dans les évaporateurs capillaires 30A, 30B, 30C, 30D. Cette augmentation de la pression de vapeur est générée au niveau des ménisques où a lieu la vaporisation totale du liquide. Ces ménisques sont formés dans la mèche capillaire où le liquide se réchauffe très rapidement et se vaporise totalement.

La vaporisation au niveau des ménisques s'effectue à température quasiconstante. L'augmentation de la pression est proportionnelle à la tension superficielle du fluide et inversement proportionnelle au rayon équivalent des ménisques.

Le débit de fluide dans chaque évaporateur est ainsi constamment autoajusté afin d'avoir uniquement de la vapeur pure à la sortie de chaque évaporateur.

On comprend que le fluide de refroidissement ainsi mis en mouvement, au niveau des évaporateurs capillaires formant pompe, voit sa phase vapeur amenée à circuler jusqu'à l'unité d'évaporation 38 où la chaleur est dissipée dans l'atmosphère conduisant à une liquéfaction du fluide de refroidissement, lequel est à nouveau aspiré par dépression vers le réservoir 32 dans lequel les évaporateurs capillaires 30A à 30D aspirent le liquide de refroidissement.

Pendant le fonctionnement du convertisseur, l'unité de pilotage 50 met en oeuvre l'algorithme illustré sur la figure 3, assurant notamment la régulation en température du fluide de refroidissement.

A l'étape 102, la puissance électrique consommée par le véhicule ferroviaire est mesurée et son évolution est détectée à l'étape 104. Si la puissance électrique augmente, le réservoir 32 est chauffé à partir de la résistance 52 à l'étape 106. Ainsi, la température de vaporisation du fluide de refroidissement à l'état liquide est augmentée, améliorant les performances thermiques dans les évaporateurs 30A à 30D.

A l'inverse, si la puissance électrique fournie par le convertisseur diminue, le réservoir 32 est refroidi à partir du ventilateur 54 à l'étape 108 pour abaisser la température de vaporisation du fluide à l'état liquide dans le réservoir 32, ce qui diminue les performances thermiques des évaporateurs capillaires.

L'unité de pilotage 50 est apte également, en cas de détection d'une température excessive, depuis le capteur 58 à commander le réchauffage du réservoir 32 pour accroître les performances de dissipation thermique dans les évaporateurs.

Enfin, l'unité 50 vérifie au cours du temps la pureté du fluide caloporteur au sein du réservoir. A cet effet, elle mesure la température Tₛₐₜ et la pression Pₛₐₜ dans le réservoir depuis les capteurs 59A et 59B. Par ailleurs, elle calcule à partir d'une formule résultant d'une modélisation, une température théorique Tₛₐₜₜₕ. Si la température théorique Tₛₐₜₜₕ est différente de la température Tₛₐₜ mesurée, alors la soupape 32A est actionnée pour dégazer, ce qui permet d'évacuer les incondensables présents dans le ciel gazeux du réservoir. Si Tₛₐₜₜₕ est égale à Tₛₐₜ mesurée, alors le fluide de refroidissement est considéré comme pur à la précision prête demandée et il n'y a pas d'intervention sur la boucle froide. Cette boucle permet de conserver plus longtemps les bonnes performances du système.

Pour compenser les pertes de fluide de refroidissement, du liquide est réintroduit périodiquement dans la boucle par l'orifice 32B.

Les étapes précédemment décrites sont effectuées en boucle.

On comprend ainsi que la température de fonctionnement de la boucle de refroidissement est contrôlée par le réservoir préssuriseur 32 diphasique. Ce réservoir est contrôlé thermiquement de manière à assurer un contrôle de sa température de vaporisation, qui permet de contrôler les performances thermiques dans les évaporateurs.

Dans ces conditions, la température de consigne, c'est-à-dire la température de jonction des organes de commutation, est contrôlée avec une bonne précision, et ce quelque soit la variation de puissance subie par la boucle au niveau des évaporateurs.

Sur la figure 4 est illustré un exemple d'un cycle de puissance électrique fournie par le convertisseur électrique lors d'un cycle de traction. Sur cette figure, la vitesse du véhicule est représentée en trait pointillé alors que la puissance consommée est représentée en trait plein. Le cycle de traction comporte une phase d'accélération, une phase de maintien de la vitesse et une phase de freinage.

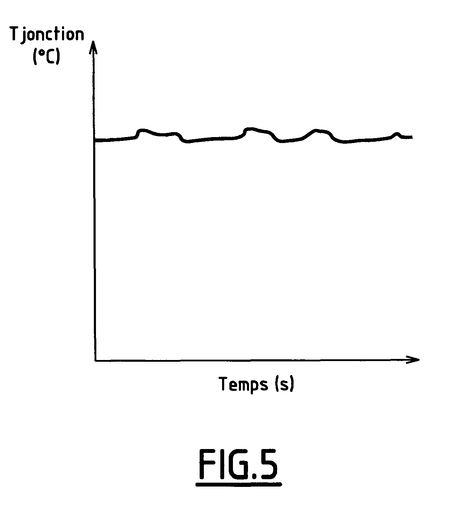

Sur la figure 5, est représentée la courbe de température de jonction des organes de commutation. Elle fait apparaître une température de jonction relativement constante alors que la puissance électrique consommée a fait l'objet de variations très importantes.

En variante, la boucle de refroidissement est commandée non pas à partir de la température de saturation du fluide dans le réservoir 32, mais à partir de la pression de saturation du fluide. Dans ces conditions, le réservoir 32 est équipé d'un compresseur et d'une vanne de mise à l'air propre à faire varier la pression du ciel gazeux dans le réservoir. Ce compresseur est relié à l'unité de pilotage 50 pour sa commande.

On comprend par ailleurs que l'alignement vertical du réservoir 32 et des évaporateurs capillaires 30A à 30D, avec le réservoir placé au-dessus des évaporateurs capillaires permet, du fait de l'action de la gravité, l'évacuation d'éventuelles bulles de vapeur formées au sein de la mèche capillaire. Les isolateurs 34 empêchent la phase vapeur d'aller directement de l'évaporateur vers le réservoir.

La description a été faite en référence à un véhicule ferroviaire mais le convertisseur peut être utilisé dans tout type de dispositif et notamment un équipement de production d'énergie comportant un générateur d'énergie électrique et un convertisseur tel que décrit ou un équipement de transmission d'énergie comportant un réseau de transport d'énergie et un convertisseur décrit.

## Revendications

1. Convertisseur de puissance électrique (10), du type comportant :
- un composant électrique de puissance (22) propre à participer à la conversion du courant électrique ;
- une boucle fermée (14) de refroidissement comprenant
- un fluide caloporteur diphasique ;
- un premier échangeur thermique (30A, 30B, 30C, 30D) appliqué contre ledit composant électrique de puissance (22) ;
- un deuxième échangeur thermique (38) propre à évacuer la chaleur du fluide caloporteur (29) hors de la boucle de refroidissement (14) ;
- des moyens (30A, 30B, 30C, 30D) de mise en circulation du fluide caloporteur dans la boucle de refroidissement (14) ;
**caractérisé en ce que** ledit premier échangeur thermique (30A, 30B, 30C, 30D) appliqué contre ledit composant électrique de puissance (22) comporte un évaporateur capillaire (30A, 30B, 30C, 30D) comportant une mèche capillaire (60) propre à assurer une vaporisation complète du fluide caloporteur (29) reçu à l'état liquide depuis une conduite (44) de transport de fluide de refroidissement, la vaporisation complète ayant lieu au niveau d'un ménisque établi dans la mèche (60) et séparant les phases liquide et vapeur du fluide caloporteur et à renvoyer le fluide caloporteur en totalité à l'état gazeux par une conduite (36) de transfert de vapeur alimentant l'entrée du deuxième échangeur thermique (38), le fluide caloporteur circulant dans la boucle de refroidissement (14) sous l'effet de la pression générée au niveau de l'interface liquide/vapeur dans l'évaporateur capillaire (30A, 30B, 30C, 30D) pour former une boucle à pompage capillaire.

2. Convertisseur de puissance électrique selon la revendication 1, **caractérisé en ce que** la boucle (14) est dépourvue de pompe mécanique de mise en circulation du fluide caloporteur.

3. Convertisseur de puissance électrique selon la revendication 1 ou 2, **caractérisé en ce qu'**il comporte, en amont de l'évaporateur capillaire (30A, 30B, 30C, 30D), un réservoir (32) de pressurisation du fluide caloporteur à l'état liquide et **en ce que** le réservoir (32) est placé à un niveau supérieur à celui de l'évaporateur capillaire (30A, 30B, 30C, 30D).

4. Convertisseur de puissance électrique selon l'une quelconque des revendications précédentes, **caractérisé en ce que** la boucle (14) comporte au moins deux évaporateurs capillaires (30A, 30B, 30C, 30D) disposés en parallèle dans la boucle (14).

5. Convertisseur de puissance électrique selon l'une quelconque des revendications précédentes, **caractérisé en ce que** le deuxième échangeur thermique propre à évacuer la chaleur du fluide caloporteur hors de la boucle de refroidissement comporte un échangeur fluide caloporteur/air (38).

6. Convertisseur de puissance électrique selon l'une quelconque des revendications précédentes, **caractérisé en ce que** la boucle (14) comporte un échangeur de sous-refroidissement (42), en aval du deuxième échangeur thermique (38) propre à évacuer la chaleur du fluide caloporteur hors de la boucle de refroidissement.

7. Convertisseur de puissance électrique selon l'une quelconque des revendications précédentes, **caractérisé en ce qu'**il comporte des moyens (50, 52, 54) de contrôle des paramètres de pression et/ou de température du fluide de refroidissement en amont de l'évaporateur capillaire (30A, 30B, 30C, 30D).

8. Convertisseur de puissance électrique selon la revendication 7, **caractérisé en ce que** les moyens de contrôle comportent un régulateur (50) assurant le contrôle de la pression et/ou de la température du fluide de refroidissement en amont de l'évaporateur capillaire en fonction de la température du composant électrique de puissance (22).

9. Convertisseur de puissance électrique selon la revendication 7 ou 8, **caractérisé en ce que** les moyens de contrôle comportent un régulateur (50) assurant le contrôle de la pression et/ou de la température du fluide de refroidissement en amont de l'évaporateur capillaire en fonction du profil de puissance électrique circulant dans le convertisseur de puissance électrique.

10. Véhicule ferroviaire comportant une chaîne de traction comportant un moteur électrique et un convertisseur de puissance électrique (10) selon l'une quelconque des revendications précédentes.

11. Equipement de production d'énergie comportant un générateur d'énergie électrique et un convertisseur selon l'une quelconque des revendications 1 à 9.

12. Equipement de transmission d'énergie comportant un réseau de transport d'énergie et un convertisseur selon l'une quelconque des revendications 1 à 9.

## Claims

1. Electric power converter (10) of the type comprising:
- an electrical power component (22) able to participate in the conversion of the electric current;
- a closed cooling loop (14) comprising:
- a diphasic heat-transfer fluid;
- a first heat exchanger (30A, 30B, 30C, 30D) applied against said electrical power component (22);
- a second heat exchanger (38) suitable for discharging the heat from the heat-transfer fluid (29) out of the cooling loop (14);
- means (30A, 30B, 30C, 30D) for circulating the heat-transfer fluid in the cooling loop (14);
**characterised in that** said first heat exchanger (30A, 30B, 30C, 30D) applied against said electrical power component (22) comprises a capillary evaporator (30A, 30B, 30C, 30D) comprising a capillary wick (60) suitable for providing complete vaporisation of the heat-transfer fluid (29) received in the liquid state from a conduit (44) transporting cooling fluid, the complete vaporisation taking place at a meniscus established in the wick (60) and separating the liquid and vapour phases of the heat-transfer fluid, and for returning the heat-transfer fluid completely in the gaseous state through a vapour transfer conduit (36) supplying the inlet of the second heat exchanger (38), the heat-transfer fluid circulating in the cooling loop (14) under the effect of the pressure generated at the liquid/vapour interface in the capillary evaporator (30A, 30B, 30C, 30D) in order to form a capillary pumping loop.

2. Electric power converter according to claim 1, **characterised in that** the loop (14) has no mechanical pump for circulating the heat-transfer fluid.

3. Electric power converter according to claim 1 or 2, **characterised in that** it comprises, upstream of the capillary evaporator (30A, 30B, 30C, 30D), a reservoir (32) for pressurising the heat-transfer fluid in the liquid state, and **in that** the reservoir (32) is placed at a level higher than that of the capillary evaporator (30A, 30B, 30C, 30D).

4. Electric power converter according to any one of the preceding claims, **characterised in that** the loop (14) comprises at least two capillary evaporators (30A, 30B, 30C, 30D) disposed in parallel in the loop (14).

5. Electric power converter according to any one of the preceding claims, **characterised in that** the second heat exchanger suitable for discharging the heat from the heat-transfer fluid out of the cooling loop comprises a heat-transfer fluid/air exchanger (38).

6. Electric power converter according to any one of the preceding claims, **characterised in that** the loop (14) comprises a subcooling exchanger (42), downstream of the second heat exchanger (38) suitable for discharging the heat from the heat-transfer fluid out of the cooling loop.

7. Electric power converter according to any one of the preceding claims, **characterised in that** it comprises means (50, 52, 54) for controlling the pressure and/or temperature parameters of the cooling fluid upstream of the capillary evaporator (30A, 30B, 30C, 30D).

8. Electric power converter according to claim 7, **characterised in that** the control means comprise a regulator (50) controlling the pressure and/or temperature of the cooling fluid upstream of the capillary evaporator according to the temperature of the electric power component (22).

9. Electric power converter according to claim 7 or 8, **characterised in that** the control means comprise a regulator (50) controlling the pressure and/or temperature of the cooling fluid upstream of the capillary evaporator according to the electric power profile circulating in the electric power converter.

10. Rail vehicle comprising a traction chain comprising an electric motor and an electric power converter (10) according to any one of the preceding claims.

11. Energy production equipment comprising an electrical energy generator and a converter according to any one of claims 1 to 9.

12. Energy transmission equipment comprising an energy transportation network and a converter according to any one of claims 1 to 9.

## Patentansprüche

1. Stromrichter (10) der Art, umfassend:
- eine elektrische Leistungskomponente (22), die geeignet ist, an der Wandlung des elektrischen Stroms beteiligt zu sein,
- einen geschlossenen Kühlkreislauf (14), umfassend
- ein Zwei-Phasen-Kühlmittel,
- einen ersten Wärmetauscher (30A, 30B, 30C, 30D), der an der genannten elektrischen Leistungskomponente (22) anliegt,
- einen zweiten Wärmetauscher (38), der geeignet ist, die Wärme des Kühlmittels (29) aus dem Kühlkreislauf (14) hinaus abzuführen,
- Mittel (30A, 30B, 30C, 30D), um das Kühlmittel im Kühlkreislauf (14) in Umlauf zu bringen,
**dadurch gekennzeichnet, dass** der genannte erste Wärmetauscher (30A, 30B, 30C, 30D), der an der genannten elektrischen Leistungskomponente (22) anliegt, einen Kapillarverdampfer (30A, 30B, 30C, 30D) umfasst, der einen Kapillardocht (60) aufweist, der geeignet ist, eine vollständige Verdampfung des Kühlmittels (29) sicherzustellen, das er in flüssigem Zustand von einer Kühlmitteltransportleitung (44) empfangen hat, wobei die vollständige Verdampfung in Höhe eines Meniskus stattfindet, der im Docht (60) besteht und die flüssige Phase und die Gasphase des Kühlmittels trennt, und das vollständig gasförmige Kühlmittel durch eine Gastranspflrtleitung (36) zurückzuführen, die in den Zulauf des zweiten Wärmetauschers (38) einleitet, wobei das Kühlmittel unter der Wirkung des Drucks, der in Höhe des Flüssigkeit/Dampf-Überganges im Kapillarverdampfer (30A, 30B, 30C, 30D) erzeugt wird, im Kühlkreislauf (14) zirkuliert, um einen Kapillarpumpenkreislauf zu bilden.

2. Stromrichter nach Patentanspruch 1, **dadurch gekennzeichnet, dass** der Kreislauf (14) keine mechanische Pumpe aufweist, um das Kühlmittel in Umlauf zu versetzen.

3. Stromrichter nach Patentanspruch 1 oder 2, **dadurch gekennzeichnet, dass** er in Strömungsrichtung vor dem Kapillarverdampfer (30A, 30B, 30C, 30D) ein Reservoir (32) zum UnterDruck-Setzen des Kühlmittels in flüssigem Zustand aufweist und dadurch, dass das Reservoir (32) höher angeordnet ist als der Kapillarverdampfer (30A, 30B, 30C, 30D).

4. Stromrichter nach irgendeinem der vorangehenden Patentansprüche, **dadurch gekennzeichnet, dass** der Kreislauf (14) mindestens zwei Kapillarverdampfer (30A, 30B, 30C, 30D) umfasst, die im Kreislauf (14) parallel angeordnet sind.

5. Stromrichter nach irgendeinem der vorangehenden Patentansprüche, **dadurch gekennzeichnet, dass** der zweite Wärmetauscher, der in der Lage ist, die Wärme des Kühlmittels aus dem Kühlkreislauf hinaus abzuführen, einen Kühlmittel/Luft-Wärmetauscher (38) aufweist.

6. Stromrichter nach irgendeinem der vorangehenden Patentansprüche, **dadurch gekennzeichnet, dass** der Kreislauf (14) einen Nachkühlwärmetauscher (42) in Strömungsrichtung nach dem zweiten Wärmetauscher (38) aufweist, der geeignet ist, die Wärme des Kühlmittels aus dem Kühlkreislauf hinaus abzuführen.

7. Stromrichter nach irgendeinem der vorangehenden Patentansprüche, **dadurch gekennzeichnet, dass** er Mittel (50, 52, 54) zur Regelung der Parameter des Drucks und/oder der Temperatur des Kühlmittels in Strömungsrichtung vor dem Kapillarverdampfer (30A, 30B, 30C, 30D) aufweist.

8. Stromrichter nach Patentanspruch 7, **dadurch gekennzeichnet, dass** die Regelungsmittel einen Regler (50) umfassen, der die Regelung des Drucks und/oder der Temperatur des Kühlmittels in Strömungsrichtung vor dem Kapillarverdampfer in Abhängigkeit von der Temperatur der elektrischen Leistungskomponente (22) sicherstellt.

9. Stromrichter nach Patentanspruch 7 oder 8, **dadurch gekennzeichnet, dass** die Regelungsmittel einen Regler (50) umfassen, der die Regelung des Drucks und/oder der Temperatur des Kühlmittels in Strömungsrichtung vor dem Kapillarverdampfer in Abhängigkeit vom Profil des elektrischen Stroms sicherstellt, der im Stromrichter fließt.

10. Schienenfahrzeug, das eine Antriebseinheit aufweist, die über einen Elektromotor und einen Stromrichter (10) nach irgendeinem der vorangehenden Patentansprüche verfügt.

11. Energieerzeugungseinrichtung, einen Stromgenerator und einen Stromrichter nach irgendeinem der Patentansprüche 1 bis 9 umfassend.

12. Energieüberkragungseinrichtung, ein Energietransportnetz aufweisend und einen Stromrichter nach irgendeinem der Patentansprüche 1 bis 9.
